# EUROPEAN PATENT SPECIFICATION

(11) **EP 1 520 446 B1**
(45) Date of publication and mention of the grant of the patent: **17.02.2010**
(21) Application number: 03727545.0
(22) Date of filing: 28.05.2003
(51) Int. Cl.: H04R 1/28, H04R 1/02

(54) **METHOD FOR FORMING ACOUSTICALLY ACTIVE ELEMENT IN A MULTI-LAYER CIRCUIT-BOARD STRUCTURE AND A MULTI-LAYER CIRCUIT-BOARD STRUCTURE**
METHODE ZUR HERSTELLUNG EINES AKUSTISCH AKTIVEN ELEMENTES IN DER STRUKTUR EINER MULTISCHICHTSCHALTPLATTE UND DIE STRUKTUR EINER MULTISCHICHTSCHALTPLATTE
PROCEDE DE FORMATION D'UN ELEMENT ACOUSTIQUEMENT ACTIF DANS UNE STRUCTURE DE CIRCUIT IMPRIME MULTICOUCHE ET STRUCTURE DE CIRCUIT IMPRIME MULTICOUCHE.

(30) Priority: 04.06.2002 FI 20021069
(43) Date of publication of application: 06.04.2005
(73) Proprietor: Aspocomp Oy, 00131 Helsinki (FI)
(72) Inventor: PÄÄRNI, Hannu, FIN-24100 Salo (FI); KUTILAINEN, Terho, FIN-90900 Kiiminki (FI); UUSIKARTANO, Matti, FIN-02880 Veikkola (FI); PENTTINEN, Auvo, FIN-00200 Helsinki (FI)
(74) Representative: Lipsanen, Jari Seppo Einari
(86) International application number: PCT/FI2003/000423
(87) International publication number: WO 2003/103334

(56) References cited:
- EP-A2- 0 497 568
- EP-A2- 0 755 167
- US-A- 4 841 493
- US-A- 6 023 518
- US-A- 6 097 828
- US-B1- 6 422 991

## Description

The present invention relates to a multi-layer circuit-board structure with an acoustically active element, according to the preamble of Claim 1.

The invention also relates to a method for forming an acoustically active element in a multi-layer circuit-board structure, and to a multi-layer circuit-board structure.

Solutions of this kind are used are used in circuit-board technology, for forming acoustically active elements, such as loudspeakers, microphones, and sensors (acceleration, pressure, humidity, etc.).

Prior art document US4841493 discloses a receiver formed in a circuit-board structure, which includes a membrane arranged acoustically in connection with a chamber (the Helmotz resonator (11)), which membrane acts as a vibrating element and is connected electrically to external circuits. Documents EP497568, US6023518 and US6097828 refer to electro-acoustic devices which are assembled on a circuit-board structure.

According to the state of the art, the attachment of separate microphone components to a circuit board takes place as a separate operation.

A drawback of the state of the art is that a separate component requires a separate attachment operation. In addition, separate components take up quite a large amount of circuit-board space, which is a critical factor in complex circuit-board constructions. The most complex circuit-board constructions are used in applications such as mobile telephones and digital cameras.

The invention is intended to create a new type of acoustically active element for a multi-layer circuit-board structure, with the aid of which the drawbacks of the state of the art described above can be eliminated.

The invention is based on forming at least the internal chamber of the acoustically active element as part of the circuit-board structure, with the aid of circuit-board processes.

More specifically, according to the invention a multi-layer circuit-board structure with the acoustically active element is characterized by what is stated in the characterizing portion of Claim 1.

The method according to the invention for forming an acoustically active element in a multi-layer circuit-board structure is, in turn, characterized by what is stated in the characterizing portion of Claim 5.

Preferably, the multi layer circuit board may have the additional features of the dependent claim 9.

Considerable advantages are gained with the aid of the invention.

With the aid of the invention, the work stage required to attach an external component is eliminated. For example, in a mobile telephone application, both the microphone and the loudspeaker can, according to the invention, be formed in connection with the manufacture of the circuit board. At the same time, the circuitry required by the component is also formed. An integrated loudspeaker/microphone can also be made smaller than a separate component, thus saving space. If additional space can be gained on the circuit board, the overall reliability of the circuit-board manufacturing process will also improve, because manufacturing faults increase statistically in proportion to any increase in the packaging density.

In the following, the invention is examined with the aid of examples and with reference to the accompanying drawings.

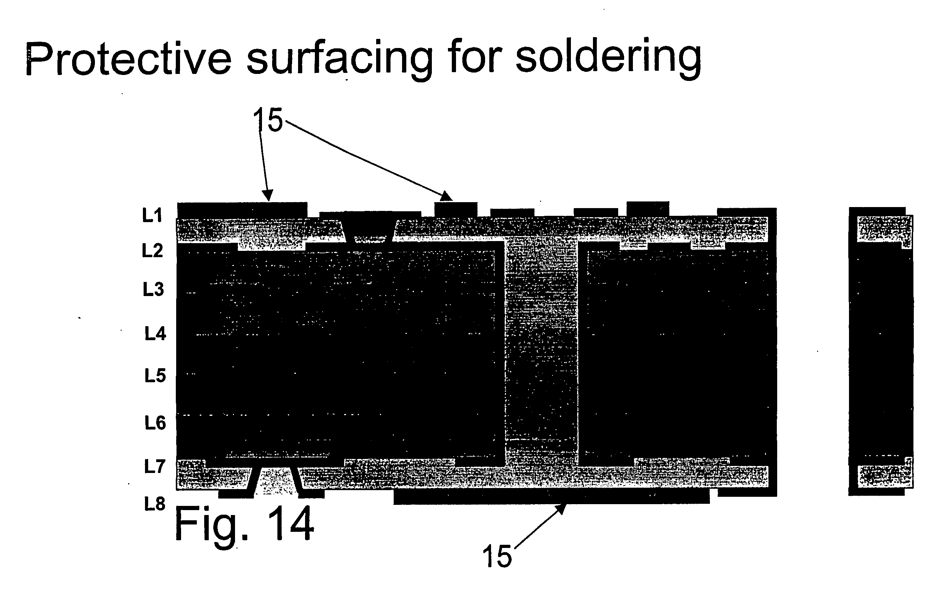

Figures 1-15 show cross-sectional side views of the circuit-board manufacturing process according to the state of the art, for instance, as follows:
Figure 1: exposure of the inner layers and transfer of the pattern.
Figure 2: etching of unexposed part and removal of protection.
Figure 3: insulation and pressing together of the layers.
Figure 4: through-drilling of the inner layers.
Figure 5: plating of the through holes to make them conducting.
Figure 6: removal of unnecessary plating.
Figure 7: formation of the microvia layers, i.e. the outer layers.
Figure 8: pressing together.
Figure 9: through-drilling.
Figure 10: pre-etching to laser.
Figure 11: creation of microvias with the aid of the laser.
Figure 12: plating of the through holes to make them conducting.
Figure 13: formation of the conducting pattern.
Figure 14: protective surfacing for soldering.
Figure 15: end product, containing buried through holes.

Figure 16a - 16e show cross-sectional side views of the stages of the method for forming a first acoustically active element, according to the invention, in a multi-layer circuit-board structure.

Figures 17a - 17e show cross-sectional side views of the stages of the method for forming a second acoustically active element, according to the invention, in a multi-layer circuit-board structure.

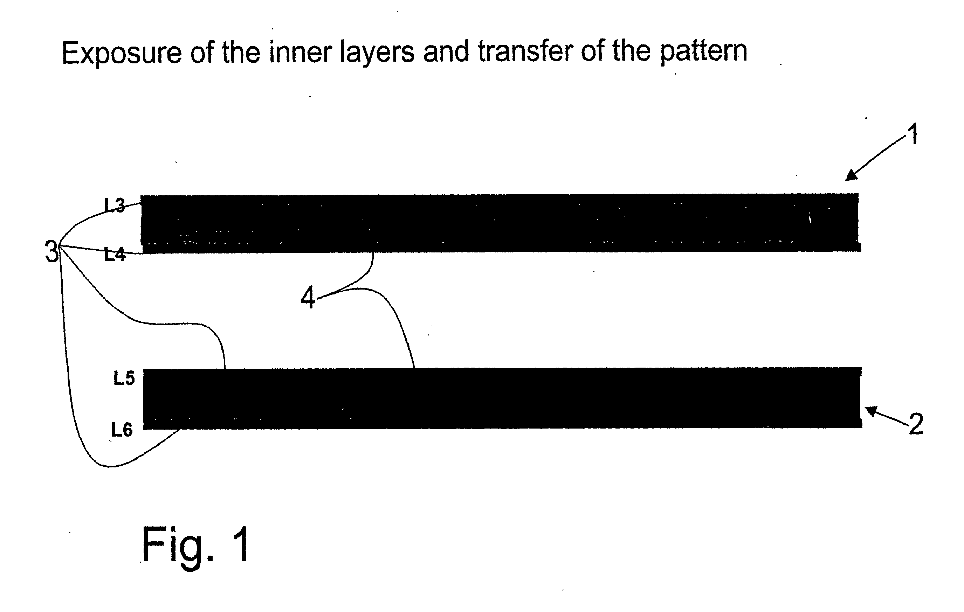

The process according to Figure 1 starts with the processing of an inner layer. The substrate of the inner layers 1 and 2 is generally glass-fibre-reinforced epoxy resin 4 (fibre reinforced organic substrate, FR4), which makes the board hard and sturdy. It is plated with copper foil 2, for the conductors and patterning. The through holes are mainly made by mechanical drilling. First of all, the circuit diagram is exposed (photolithography, imaging) on a light-sensitive material, from which the pattern is transferred to the active surface (copper plating) of the board (or of the layer to be processed). The first to be processed are the conducting surfaces 3 of the innermost circuit board blanks 1 and 2, which are separated from each other with insulating material 4.

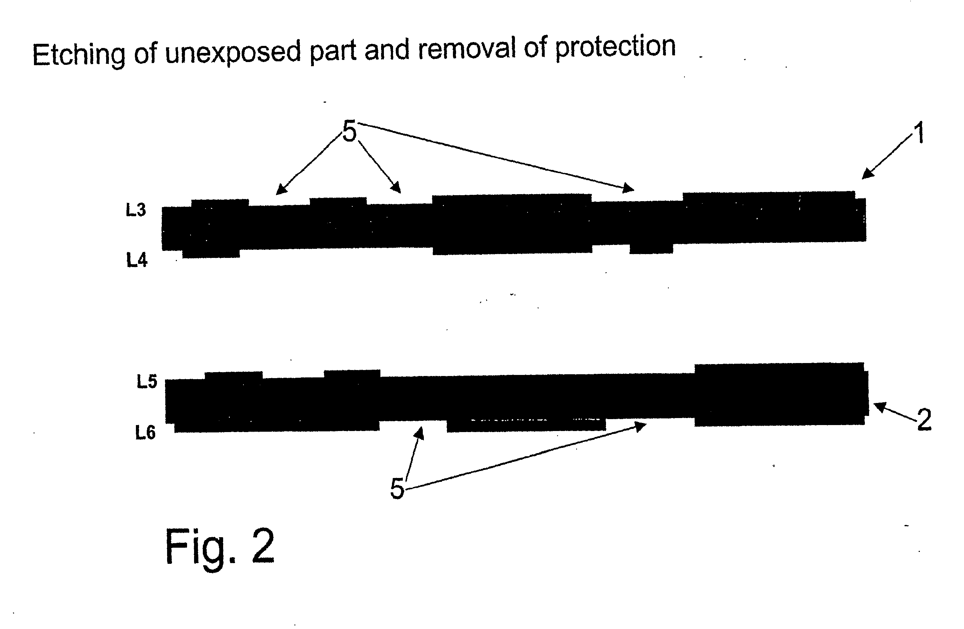

The exposure stage demands clean rooms and special clothing for the operators. During 'development' a protective surface is formed on top of the copper in the pattern areas, while in the other areas the excess copper is etched away. This leads to an end result according to Figure 2, in which the reference number 5 shows the areas, from which the conducting copper has been etched away.

Finally the protective material is washed off (stripped) from on top of the conductors. After this, only protective surface treatment remains to be carried out.

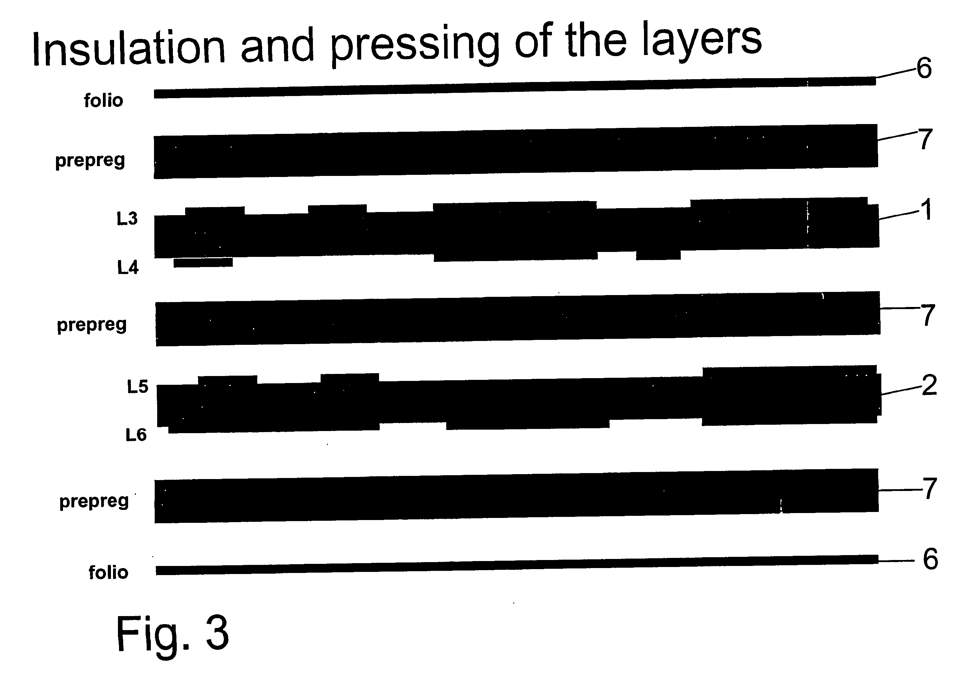

According to Figure 3, insulating material (prepreg-) 7 is placed between the various layers while conducting layers are made on their outer surfaces. The various layers are pressed together (pressing) in a stage demanding precise positioning.

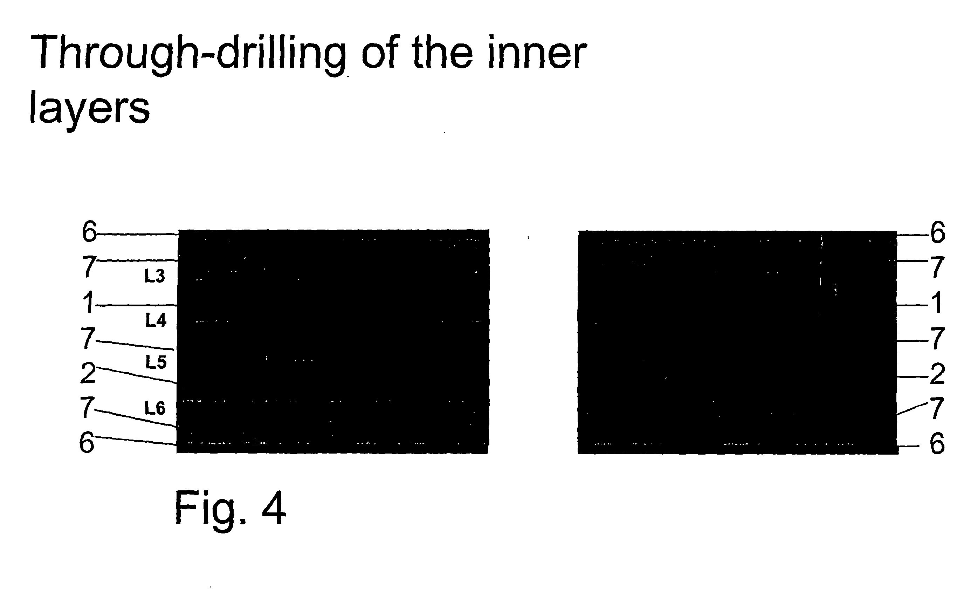

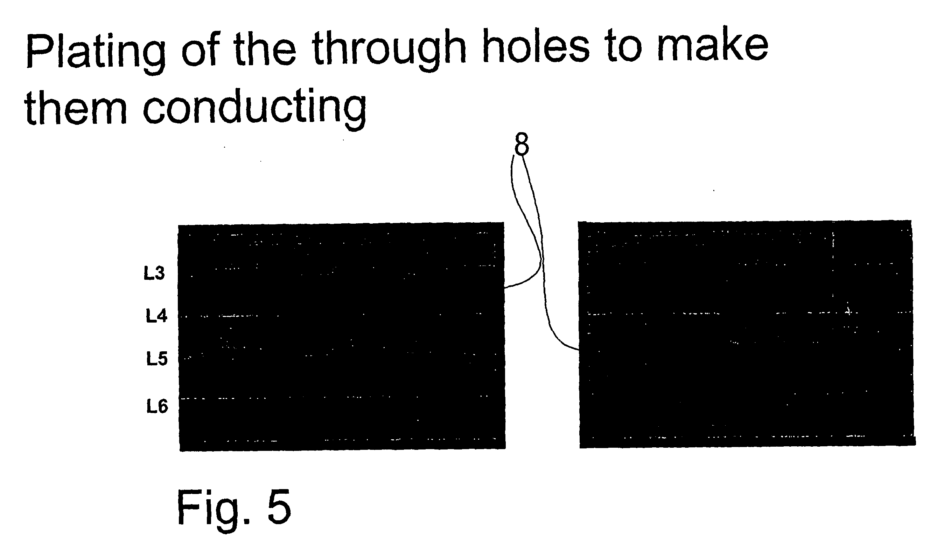

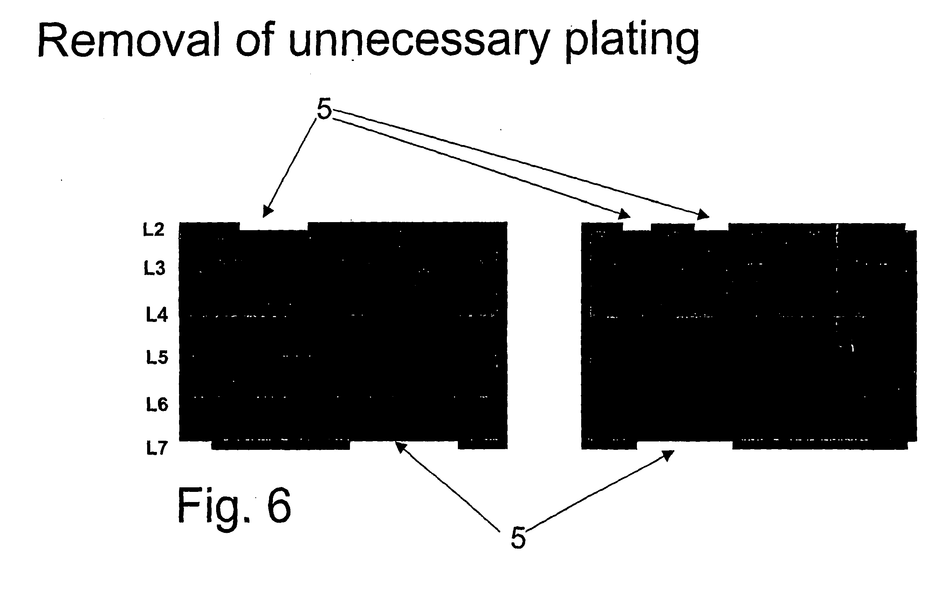

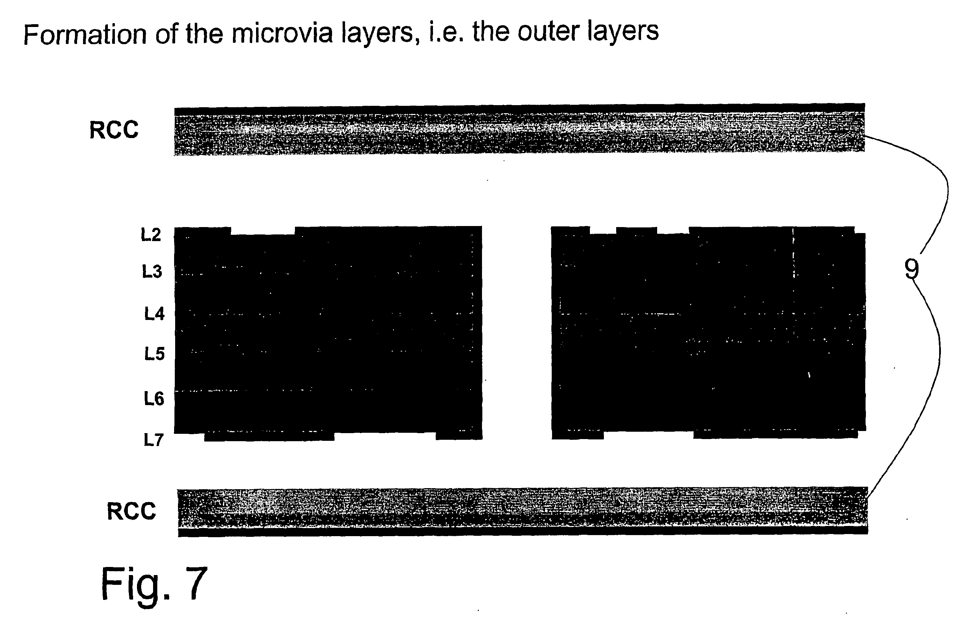

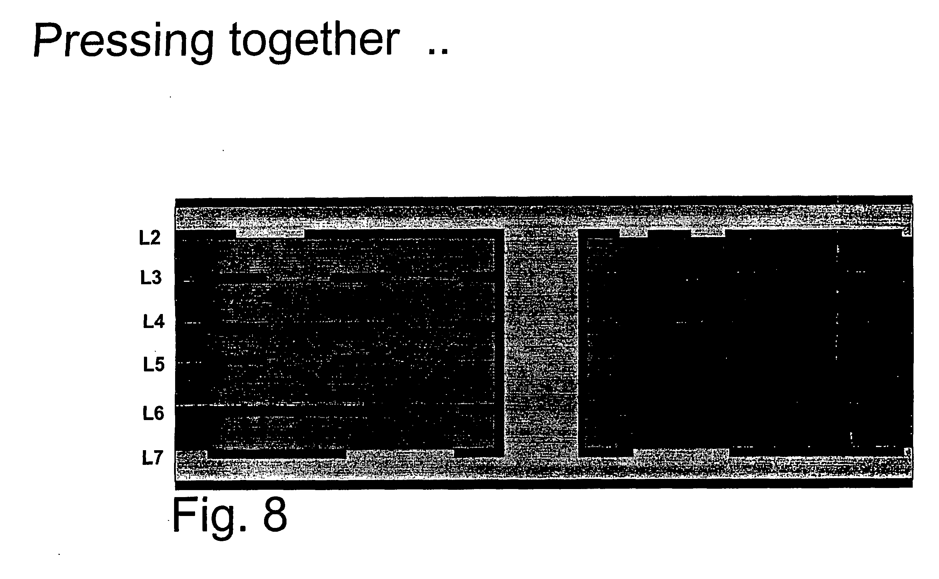

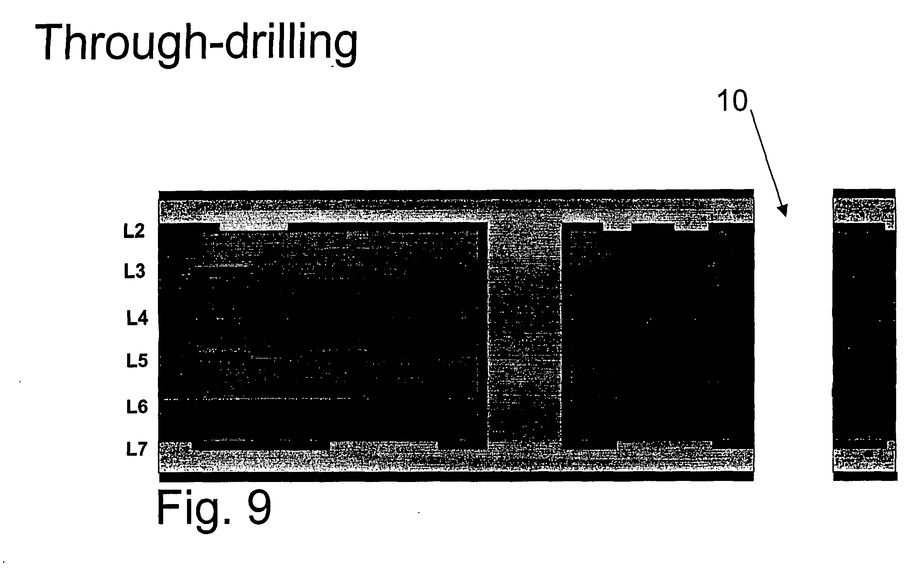

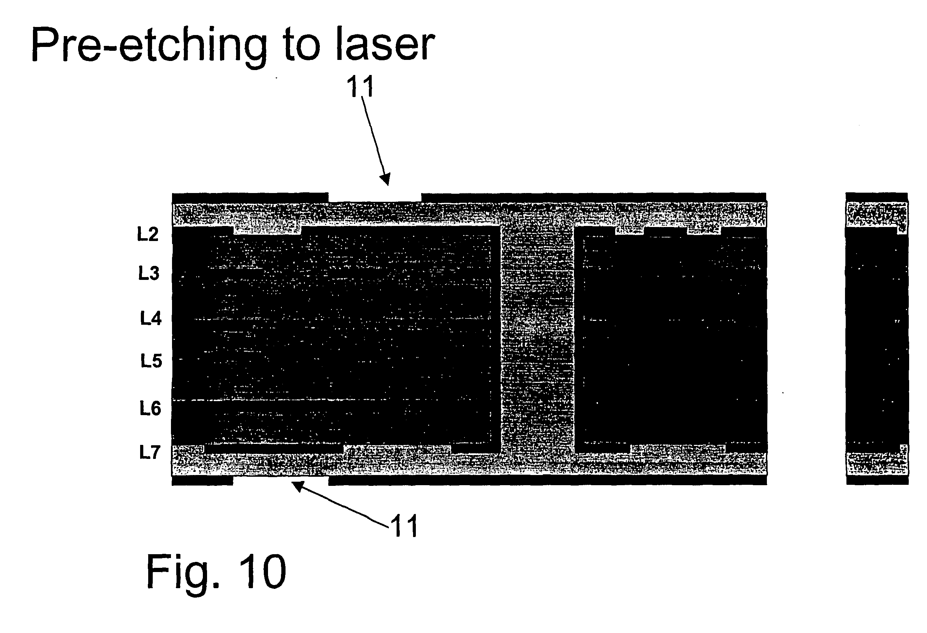

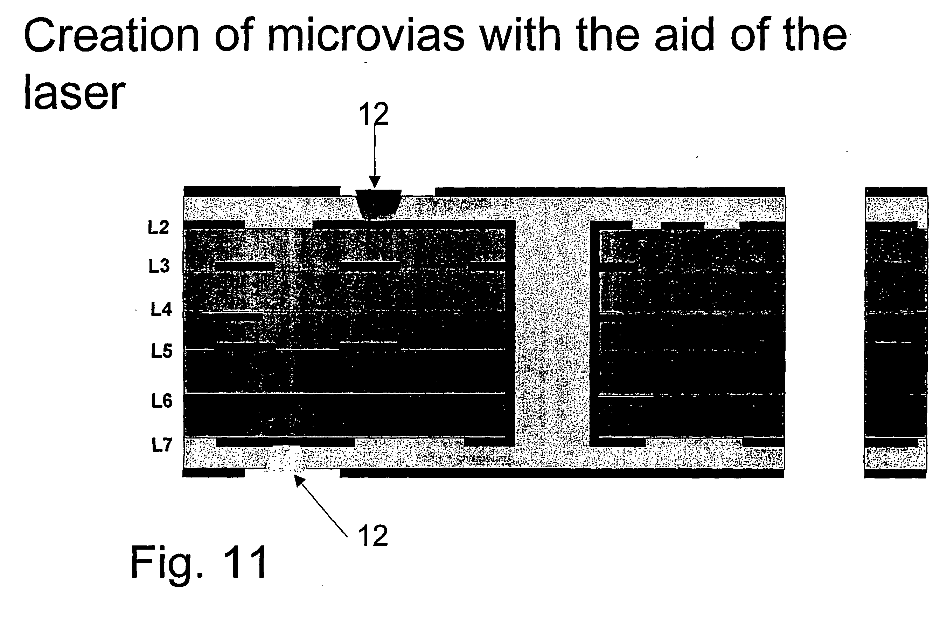

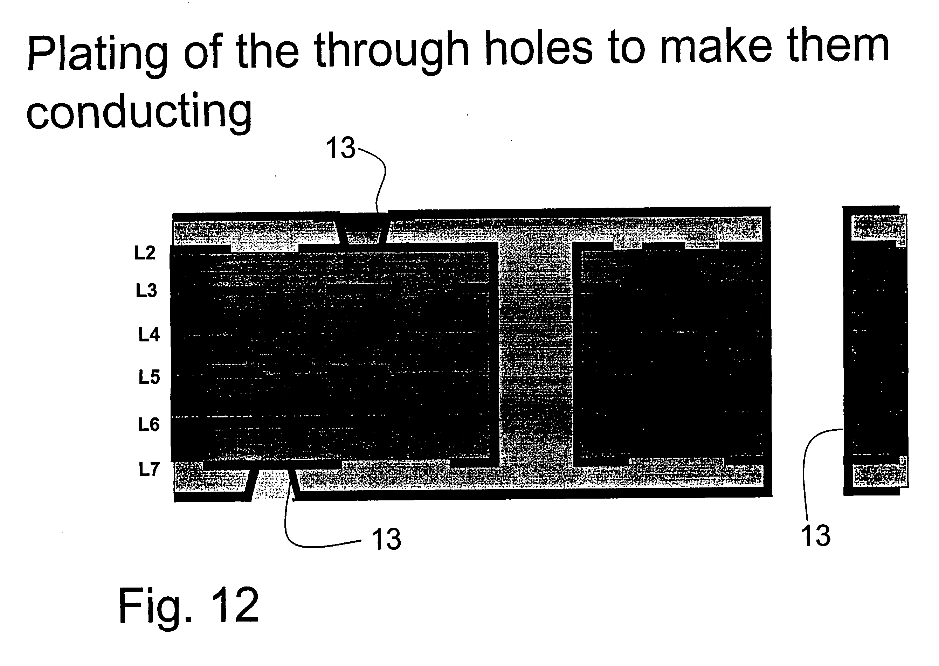

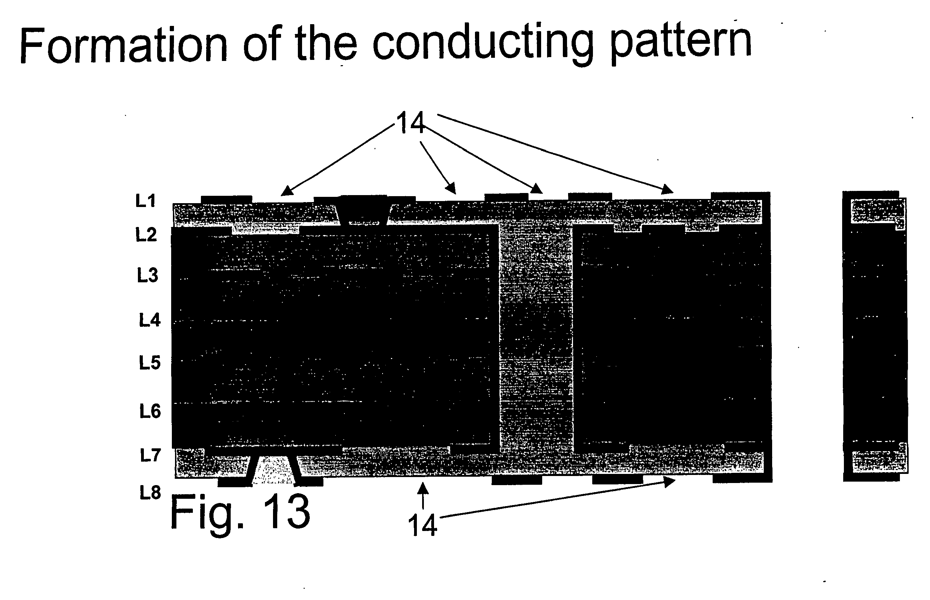

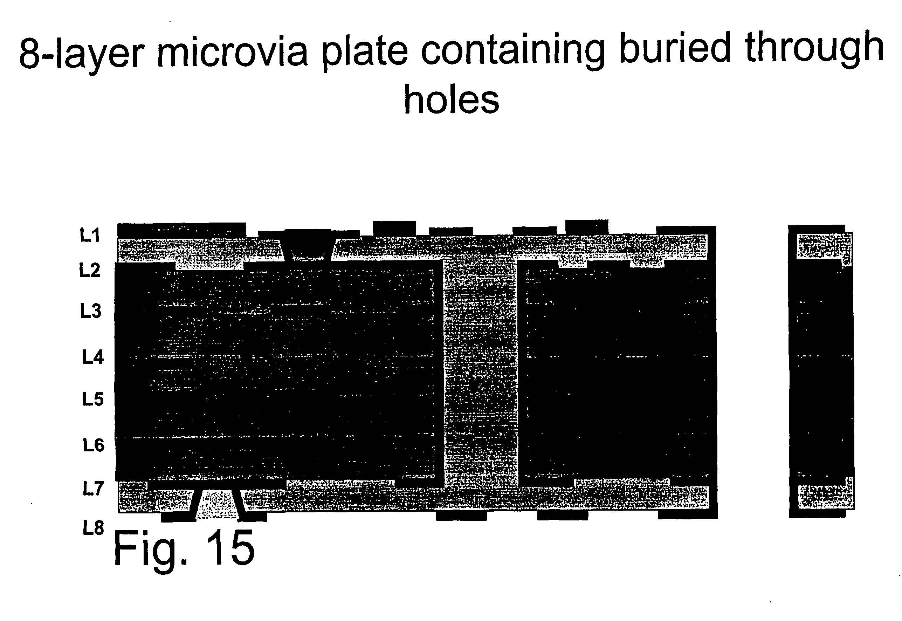

According to Figure 4, the through holes are drilled, and, according to Figure 5, are plated to become conducting. According to Figure 6, the unnecessary conducting plating is removed, using the previously described photolithographic methods, the areas removed being shown in this case too with the reference number 5. The outer layers 9 (microvias) are formed according to Figures 7 and 8 and drill holes 10 running through the entire board are made according to Figure 9. The areas 11 of the outer layers are pre-etched for the laser, according to Figure 10. Microvias 12 are made in the areas 11 according to Figure 11 and the through holes are plated 13, according to Figure 12. According to Figure 13, conducting patterns are further formed on the outermost conducting membranes, using the photolithographic methods described previously. After this, protective surfacing 15 is formed for soldering, the final result obtained being a structure according to Figure 15, containing buried through holes. Finally, the board is finished and manufacturer's and code markings are made on it. Both optical and electrical testing takes place at the various stages of the process. As a totality, the end product can be divided into an outer layer, to which the external components are attached, and an inner layer, which implements the basic connections.

Generally there are about 20 - 40 process stages. The process demands expertise in chemistry and physics. In particular, it demands expertise in the theory of electricity and in physical chemistry.

The microvia layers 9 shown in Figures 7 - 9 are made as follows:

Depending on the application, the material substrates and processing processes of the outer layer and the inner layer may differ from each other.

In the latest devices (mobile telephones and new-generation base stations) a microvia layer 9 is the outer layer. This layer is used, because the increase in the number of component connections demands a reduction in the size of the through holes and conductors.

The microvias 12 (Figure 11) are made by burning with a laser. In general, a through hole is termed a microvia, if its diameter is < 100 microns, in which case mechanical drilling devices are insufficiently precise.

The vias 12 can be blind, in which case they terminate, for example, at layer L3. A buried via is a through hole that is not visible on the surface, but which runs, for example, between levels L2 and L3 (e.g., Figure 6).

The material of the microvia layer 9 is usually RCC (Resin Coated Copper). The conductive outer plating is thin copper foil.

New technologies will increase the microvia layers. The term HDI (High Density Interconnection) board refers to a circuit board with a line width/spacing of < 100 microns.

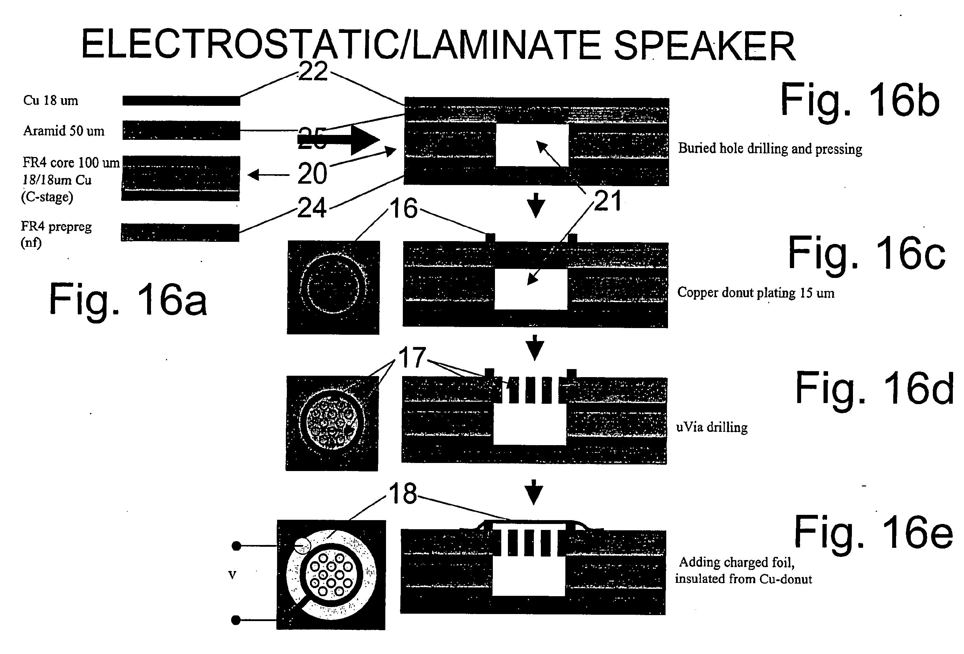

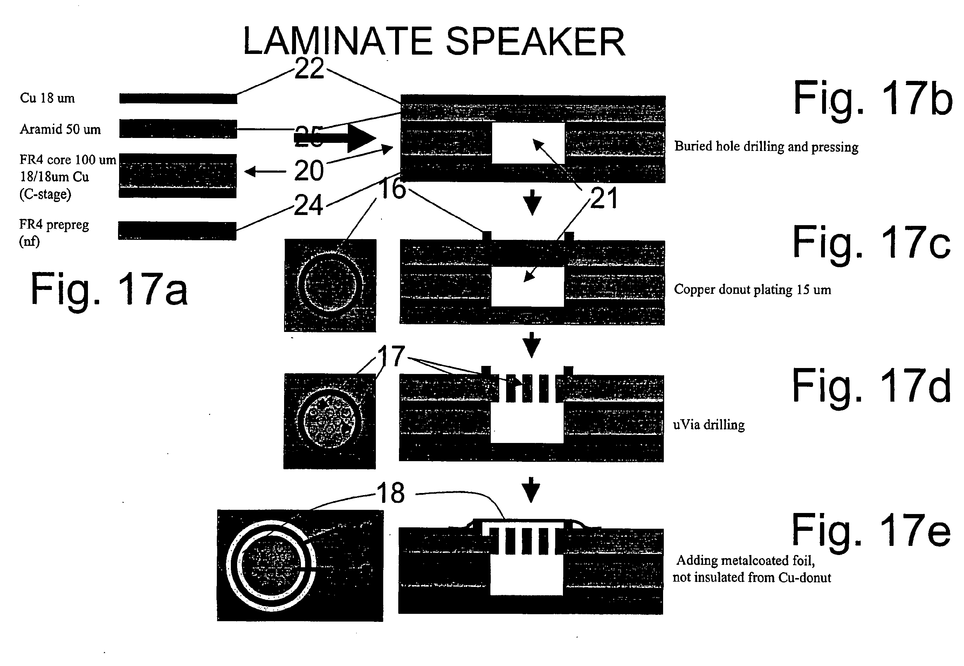

The process according to the invention for forming a loudspeaker, shown in Figures 16 and 17, basically follows the stages described above, all the materials being commercially available circuit-board materials.

The internal part 20 is normal FR4, described above, which is plated with copper. In the inner part, an interior chamber 21 is formed by normal circuit-board processes (routing or drilling) while the necessary conducting pattern is made on the surface 22, using lithography and etching.

The surface layers are formed as follows: on one side a socket 24 of FR4 and on the other a copper connecting layer 22, for example, insulated by aramid fibre 25. Lithography and etching are used to make the necessary conducting pattern on the connecting layer 22.

Aramid is an insulating fibre material using in the circuit-board industry, and is a normal commercially available material.

According to Figure 16b, the layers are laminated together, by using normal circuit-board manufacturing devices.

According to Figure 16c, an annular copper structure 16, which acts as a support structure for the acoustic membrane and if necessary as an intermediary for electrical contacts, is made in the multi-layer structure by image transfer, i.e. lithography. The process of growing the annular structure can be electrolytic or chemical (autocatalysis).

Inside the annular structure 16 microvias 17 are made to form acoustic channels, using normal circuit-board industry laser devices.

The acoustic membrane 18 is tensioned with the aid of the annular structure 18 and to the multi-layer structure by an adhesion substance.

According to Figure 16e, the membrane 18 can be equipped with a permanent charge, or alternatively metallized according to Figure 17e. In these alternative embodiments, the conductor pattern and the manner of routing the signals is different; in the former case (Figure 16e) the charge of the membrane acts as the bias while in the latter (Figure 17e) it is a separate voltage led under the membrane, in which case the signal is taken to the metallized membrane 18.

## Claims

1. A multi-layer circuit-board structure (20, 22, 24, 25), with an acoustically active element, wherein said acoustically active element includes:
- an internal chamber (21), and
- a membrane (18) arranged acoustically in connection with the internal chamber (21), which acts as a vibrating element and is connected electrically to external circuits, in order to produce or measure an acoustic effect,
**characterized in that**
- the internal chamber (21) is formed inside the multi-layer circuit-board structure (20, 22, 24, 25).

2. A multi-layer circuit-board structure according to Claim 1, **characterized in that** the membrane (18) acting as a vibrating element is stretched on top of an annular element (16) formed in the multi-layer circuit-board structure (20, 22, 24, 25).

3. A multi-layer circuit-board structure according to Claim 1 or 2, **characterized in that** the membrane (18) acting as a vibrating element is electrically charged.

4. A multi-layer circuit-board structure according to any of the above Claims, **characterized in that** the annular element (18) is formed from copper on the surface of the multi-layer circuit-board structure.

5. A method for forming an acoustically active element in a multi-layer circuit-board structure, in which method the multi-layer circuit-board structure is formed of alternating insulating (25, 24) and conducting layers (22), contacts being formed between the conducting layers (22), and conducting structures being imaged in the conducting layers,
**characterized in that**
- an acoustic internal chamber (21) is formed inside the multi-layer circuit-board structure (20, 22, 24, 25),
- the internal chamber is opened (17) to the surface of the circuit board, and
- a membrane (18) capable of vibrating and connected electrically to external circuits is formed on top of the internal chamber (21) opened to the surface.

6. A method according to Claim 5, **characterized in that** the internal chamber (21) is opened using the microvia technique.

7. A method according to Claim 5 or 6, **characterized in that** an annular structure (16), on top of which the membrane (18) capable of vibrating is installed, is formed on the surface of the circuit board.

8. A method according to claim 5 or 6, **characterized in that** the membrane (18) capable of vibrating is electrically charged.

9. A multi-layer circuit-board structure according to claim 1 for forming an acoustically active element in, which circuit-board structure includes
- alternating insulating (25, 24) and conducting layers (22),
- contacts formed between the conducting layers (22), and
- conducting structures forming patterns in the conducting layers,
**characterized in that** the multi-layer circuit-board structure includes
- a built-in acoustic internal chamber (21), and
- a membrane (18) capable of vibrating formed on top of the internal chamber (21) and connected electrically to external circuits.

10. A multi-layer circuit-board structure according to Claim 9, **characterized in that** the membrane (18) acting as a vibrating element is stretched on top of an annular element (16) formed in the multi-layer circuit-board structure (20, 22, 24, 25).

11. A multi-layer circuit-board structure according to Claim 9 or 10, **characterized in that** the membrane (18) capable of vibrating is electrically charged.

12. A multi-layer circuit-board structure according to claims 9 to 11, **characterized in that** an annular element (18) is formed from copper on the surface of the multi-layer circuit-board structure.

## Patentansprüche

1. Mehrschicht-Leiterplattenstruktur (20, 22, 24, 25) mit einem akustisch aktiven Element, wobei das akustisch aktive Element aufweist:
- eine Innenkammer (21), und
- eine Membran (18), die akustisch in Verbindung mit der Innenkammer (21) angeordnet ist, die als Vibrationselement fungiert und elektrisch an externe Schaltungen angeschlossen ist, um einen akustischen Effekt hervorzurufen oder zu messen,
**dadurch gekennzeichnet, dass**
- die Innenkammer (21) im Inneren der Mehrschicht-Leiterplattenstruktur (20, 22. 24, 25) ausgebildet ist.

2. Mehrschicht-Leiterplattenstruktur nach Anspruch 1, **dadurch gekennzeichnet, dass** die als Vibrationselement fungierende Membran (18) oben auf einem ringförmigen Element (16) ausgestreckt ist, welches in der Mehrschicht-Leiterplattenstruktur (20, 22, 24, 25) ausgebildet ist.

3. Mehrschicht-Leiterplattenstruktur nach Anspruch 1 oder 2, **dadurch gekennzeichnet, dass** die als Vibrationselement fungierende Membran (18) elektrisch aufgeladen ist.

4. Mehrschicht-Leiterplattenstruktur nach einem der obigen Ansprüche, **dadurch gekennzeichnet, dass** das ringförmige Element (18) aus Kupfer auf der Oberfläche der Mehrschicht-Leiterplattenstruktur gebildet ist.

5. Verfahren zum Ausbilden eines akustisch aktiven Elements in einer Mehrschicht-Leiterplattenstruktur, bei welchem Verfahren die Mehrschicht-Leiterplattenstruktur gebildet wird aus abwechselnd isolierenden (25, 24) und leitenden Schichten (22), wobei zwischen den leitenden Schichten (22) Kontakte gebildet und leitende Strukturen in die leitenden Schichten abgebildet werden,
**dadurch gekennzeichnet, dass**
- eine akustische Innenkammer (21) im Inneren der Mehrschicht-Leiterplattenstruktur (20, 22, 24, 25) gebildet wird,
- die Innenkammer zur Oberfläche der Leiterplatte hin offen (17) ist, und
- eine schwingfähige Membran (18), die elektrisch mit externen Schaltungen verbunden ist, oben auf der zu der Oberfläche geöffneten Innenkammer (21) ausgebildet wird.

6. Verfahren nach Anspruch 5, **dadurch gekennzeichnet, dass** die Innenkammer (21) mit Hilfe der Microvia-Methode gebildet wird.

7. Verfahren nach Anspruch 5 oder 6, **dadurch gekennzeichnet, dass** eine ringförmige Struktur (16), auf welcher oben die schwingfähige Membran (18) installiert wird, auf der Oberfläche der Leiterplatte gebildet wird.

8. Verfahren nach Anspruch 5 oder 6, **dadurch gekennzeichnet, dass** die schwingfähige Membran (18) elektrisch aufgeladen wird.

9. Mehrschicht-Leiterplattenstruktur nach Anspruch 1 zur Ausbildung eines akustisch aktiven Elements in ihr, wobei die Leiterplattenstruktur enthält:
- abwechselnde isolierende (25, 24) und leitende Schichten (22),
- zwischen den leitenden Schichten (22) gebildete Kontakte, und
- leitende Strukturen, die in den leitenden Schichten Muster bilden,
**dadurch gekennzeichnet, dass** die Mehrschicht-Leiterplattenstruktur enthält:
- eine eingebaute akustische Innenkammer (21), und
- eine schwingfähige Membran (18), die oben auf der Innenkammer (21) gebildet ist und elektrisch mit externen Schaltkreisen verbunden ist.

10. Mehrschicht-Leiterplattenstruktur nach Anspruch 9, **dadurch gekennzeichnet, dass** die als Vibrationselement fungierende Membran (18) oben auf einem ringförmigen Element (16) ausgestreckt ist, welches in der Mehrschicht-Leiterplattenstruktur (20, 22, 24, 25) ausgebildet ist.

11. Mehrschicht-Leiterplattenstruktur nach Anspruch 9 oder 10, **dadurch gekennzeichnet, dass** die schwingfähige Membran (18) elektrisch aufgeladen ist.

12. Mehrschicht-Leiterplattenstruktur nach den Ansprüchen 9 bis 11, **dadurch gekennzeichnet, dass** das ringförmige Element (18) aus Kupfer auf der Oberfläche der Mehrschicht-Leiterplattenstruktur ausgebildet ist.

## Revendications

1. Structure de carte de circuit imprimé multicouche (20, 22, 24, 25), avec un élément acoustiquement actif, dans laquelle ledit élément acoustiquement actif comprend :
- une chambre interne (21), et
- une membrane (18) agencée acoustiquement en connexion avec la chambre interne (21), qui agit comme un élément vibrant et est connectée électriquement à des circuits externes, afin de produire ou de mesurer un effet acoustique,
**caractérisée en ce que**
- la chambre interne (21) est formée à l'intérieur de la structure de carte de circuit imprimé multicouche (20, 22, 24, 25).

2. Structure de carte de circuit imprimé multicouche selon la revendication 1, **caractérisée en ce que** la membrane (18) agissant comme un élément vibrant est étirée sur la partie supérieure d'un élément annulaire (16) formée dans la structure de carte de circuit imprimé multicouche (20, 22, 24, 25).

3. Structure de carte de circuit imprimé multicouche selon la revendication 1 ou 2, **caractérisée en ce que** la membrane (18) agissant comme un élément vibrant est chargée électriquement.

4. Structure de carte de circuit imprimé multicouche selon l'une quelconque des revendications précédentes, **caractérisée en ce que** l'élément annulaire (18) est formé de cuivre sur la surface de la structure de carte de circuit imprimé multicouche.

5. Procédé pour former un élément acoustiquement actif dans une structure de carte de circuit imprimé multicouche, procédé dans lequel la structure de carte de circuit imprimé multicouche est formée de couches alternées isolantes (25, 24) et conductrices (22), des contacts étant formés entre les couches conductrices (22), et des structures conductrices étant imagées dans les couches conductrices,
**caractérisé en ce que**
- une chambre interne acoustique (21) est formée à l'intérieur de la structure de carte de circuit imprimé multicouche (20, 22, 24, 25),
- la chambre interne est ouverte (17) sur la surface de la carte de circuit imprimé, et
- une membrane (18) capable de vibrer et connectée électriquement à des circuits externes est formée sur la partie supérieure de la chambre interne (21) ouverte sur la surface.

6. Procédé selon la revendication 5, **caractérisé en ce que** la chambre interne (21) est ouverte par utilisation de la technique Microvia.

7. Procédé selon la revendication 5 ou 6, **caractérisé en ce qu'**une structure annulaire (16) sur la partie supérieure de laquelle est installée la membrane (18) capable de vibrer, est formée sur la surface de la carte de circuit imprimé.

8. Procédé selon la revendication 5 ou 6, **caractérisé en ce que** la membrane (18) capable de vibrer est chargée électriquement.

9. Structure de carte de circuit imprimé multicouche selon la revendication 1 pour former un élément acoustiquement actif, dans laquelle la structure de carte de circuit imprimé comprend
- des couches alternées isolantes (25, 24) et conductrices (22).
- des contacts formés entre les couches conductrices (22), et
- des structures conductrices formant des motifs dans les couches conductrices,
**caractérisée en ce que** la structure de carte de circuit imprimé multicouche comprend
- une chambre interne acoustique incorporée (21), et
- une membrane (18) capable de vibrer formée sur la partie supérieure de la chambre interne (21) et connectée électriquement à des circuits externes.

10. Structure de carte de circuit imprimé multicouche selon la revendication 9, **caractérisée en ce que** la membrane (18) agissant comme un élément vibrant est étirée sur la partie supérieure d'un élément annulaire (16) formé dans la structure de carte de circuit imprimé multicouche (20, 22, 24, 25).

11. Structure de carte de circuit imprimé multicouche selon la revendication 9 ou 10, **caractérisée en ce que** la membrane (18) capable de vibrer est chargée électriquement.

12. Structure de carte de circuit imprimé multicouche selon les revendications 9 à 11, **caractérisée en ce qu'**un élément annulaire (18) est formé de cuivre sur la surface de la structure de carte de circuit imprimé multicouche.
